# EUROPEAN PATENT APPLICATION

(11) **EP 0 608 551 A1**
(43) Date of publication of application: **03.08.1994**
(21) Application number: 93120681.7
(22) Date of filing: 22.12.1993
(51) Int. Cl.: H01L 29/40, C23C 14/34, C23C 14/06, H01L 21/283, H01L 21/3205

(54) **Method of forming ohmic contact by sputtering a TiN layer for LSI circuit and LSI circuit**

(30) Priority: 28.12.1992 JP 359885/92
(71) Applicant: HITACHI METALS CO. LTD., Chiyoda-ku, Tokyo 100 (JP); Oki Electric Industry Co., Ltd., Tokyo (JP)
(72) Inventor: Kubota, Kunichika, Yasugi-shi (JP); Hirakawa, Eiji, Yasugi-shi (JP); Hiraki, Akitoshi, Yasugi-shi (JP)
(74) Representative: Patentanwälte Beetz - Timpe - Siegfried Schmitt-Fumian - Mayr

(57) **Abstract**

Disclosed in this invention is an LSI ohmic contact forming method which comprises carrying out sputtering on a silicon substrate by using a target substantially composed of titanium and nitrogen and having a nitrogen to titanium atomic ratio of less than 1 to form on the silicon substrate a thin film of a titanium and nitrogen composition with a nitrogen to titanium atomic ratio of less than 1, and then subjecting the thin film to a heat treatment to let the film react with silicon to form titanium silicide on the silicon side of the film. According to this method, there can be formed a titanium silicide layer with a small and uniform thickness and a titanium nitride layer with a sufficiently large thickness.

## Description

The present invention relates to a method for forming ohmic contact connecting the silicon semiconductor composing LSI and the wiring formed thereon, and an LSI having a specific ohmic contact. More particularly, the invention pertains to an ohmic contact forming method featuring use of titanium nitride for the diffusion preventive layer and an LSI having such an ohmic contact.

With a recent tendency toward higher integration of LSI, the P type or N type doped layer is required to be formed to a smaller depth in a more limited area below the contact hole.

In case the doped layer of LSI is small in depth, if wiring of aluminum or other metal is directly formed on a silicon substrate, there tends to take place a mutual diffusion reaction, causing aluminum or other metal to easily break through the doped layer to destroy the semiconductor junction.

In order to prevent such a mutual diffusion reaction, it is practiced in the art to form a diffusion preventing layer (which is also called "barrier metal layer") composed of a high-melting point material such as a titanium-tungstem alloy or a titanium nitride compound between the wiring and the silicon substrate.

Among the known materials used for forming a diffusion preventive layer, the titanium nitride compounds are considered to have an especially excellent diffusion preventive action, and studies are being prosecuted for lowering their contact resistance with the silicon substrate.

As means for lowering contact resistance between the silicon substrate and the titanium nitride layer, it has been proposed and found effective to form a titanium silicide layer of low contact resistance between the titanium nitride compound layer and the silicon substrate, as for instance described in a Monthly Semiconductor World, Dec., 1992, pp. 196-205, or Dec., 1989, pp. 189-192.

For forming a titanium silicide layer, there are usually employed the following methods: (1) As described in the above literature, a thin film of pure titanium is formed on a silicon substrate by sputtering and then subjected to a heat treatment in a nitrogen or ammonia gas atmosphere to nitride the surface layer of the pure titanium film so as to form a titanium nitride compound layer while reacting the pure titanium film with the silicon substrate to form titanium silicide; (2) An ultra-thin film of pure titanium is formed by sputtering and heat treated to form a titanium silicide film, and this titanium silicide film is subjected to reactive sputtering in which nitrogen in the sputtering gas is reacted with the titanium target to form a titanium nitride film of a stoichiometric composition. Both methods coincide in that the pure titanium film is reacted with the silicon substrate.

Another method (3) is also tried in which, as shown in Applied Surface Science, 41/42 (1989), 272-276, pure titanium is used as target and a TiNₓ film is formed by an ion plating method comprising reacting said titanium target with nitrogen in a gaseous phase, and this TiNₓ film is heat treated to induce a siliciding reaction while transferring nitrogen in the film to the film surface so as to form a titanium nitride surface layer close to the stoichiometric composition.

As described above, various methods are available for forming a diffusion preventive layer for ohmic contact. However, with further elevation of the degree of integration of LSI in recent years, it is required to make smaller the diameter of the contact hole for forming ohmic contact and to also make smaller the depth of the doped layer formed below the contact hole.

In case a doped layer of a smaller depth is formed, it needs to make as uniform and thin as possible the titanium silicide layer formed at the interface between the diffusion preventive layer and the doped layer. This is necessary for preventing the thin doped layer on the silicon substrate from being corroded excessively since titanium silicide is produced by consuming silicon of the silicon substrate.

According to the above method (2) in which a pure titanium film is previously formed for producing titanium silicide, it is difficult to make uniform the film thickness due to the influence of shadowing by the side wall of the contact hole, so that in order to sufficiently cover the bottom of the contact hole with the titanium film, it is necessary to enlarge the thickness of the titanium film.

Enlarged thickness of the titanium film, however, gives rise to the problem of increased consumption of silicon of the substrate reacted with titanium, making it unable to form a thin titanium silicide layer.

In the case of the method (1) in which the pure titanium film is heat treated in a nitriding atmosphere and a titanium nitride layer and a silicide layer are formed by a nitriding reaction and a siliciding reaction, respectively, it is possible to make the thickness of the titanium silicide layer smaller than possible with the method (2) since the surface layer portion of the titanium film is consumed for the nitriding reaction. However, because of low rate of formation of the titanium nitride layer by supply of nitrogen from a gaseous phase, it is difficult to form a titanium nitride layer with a sufficient thickness to serve as a diffusion preventive layer.

In view of the above, the present inventors had an eye to and made closer study on the method (3) in which a TiNₓ film, or a thin film of titanium nitride with a greater content of titanium than the stoichiometric composition, is subjected to a siliciding reaction and, as a result, it was found that according to this method, the desired titanium silicide layer can be formed by a single run of sputtering, and since nitrogen exists in the film from the beginning, no restrictions are imposed on the nitrogen feed rate from the gaseous phase, and it is possible to form a titanium nitride layer with a sufficient thickness to function as a diffusion preventive layer.

However, as mentioned in Applied Surface Science 41/42 (1989), 272-276, in which the method (3) is disclosed, the method (3) involves the problem that a titanium silicide film is formed only partially or in an insular formation at the titanium nitride-silicon interface and cannot be provided with a uniform thickness. One of the causes thereof is that pure titanium is used as the target as described later and a chemical reaction between titanium and nitrogen is used for forming a TiNₓ film.

The object of the present invention is to provide an LSI ohmic contact forming method according to which it is possible to form a titanium silicide layer with a small and uniform thickness and to form a titanium nitride layer with a desired thickness, and an LSI having a novel diffusion preventive layer structure.

The present inventors have tried to form a film by using a sputtering target of a TiNₓ composition very close to the thin film composition in place of conventionally used pure titanium and to subject the obtained film to a siliciding reaction by a heat treatment to form a titanium nitride layer and a titanium silicide layer on a silicon substrate, and as a result, found that according to this method, it is possible to obtain a titanium silicide layer with a small and uniform thickness which could never be obtained with the conventional techniques and to form a titanium nitride layer with a sufficient thickness for serving as a diffusion preventive layer. The present invention was attained on the basis of this finding.

One of the characteristic features of the present invention resides in that a TiNₓ film is formed by sputtering with a titanium nitride target (hereinafter referred to as TiNₓ target) having a higher content of titanium than the stoichiometric composition (TiN).

Thus, the present invention is an LSI ohmic contact informing method which comprises forming on a silicon substrate a thin film (synonymous with the above-mentioned TiNₓ film) of a composition with a nitrogen to titanium atomic ratio of less than 1 by sputtering with a target (synonymous with the above-mentioned TiNₓ target) substantially composed of titanium and nitrogen, in which the nitrogen to titanium atomic ratio is less than 1, and subjecting this thin film to a heat treatment to let said thin film react with silicon to form titanium silicide on the silicon side of said thin film.

Fig. 1 is a graph showing the relationship between the sputtering target composition and the titanium nitride layer to titanium silicide layer thickness ratio in the thin film which has been subjected to a simple heat treatment.

Fig. 2 is a graph showing the relationship between the sputtering target composition and the titanium nitride layer to titanium silicide layer thickness ratio in the thin film which has been subjected to a thermal nitriding treatment.

Fig. 3 is a photograph showing a typical film structure according to the present invention.

The above heat treatment is intended to ultimately form a titanium silicide layer on the silicon side of said thin film while forming a titanium nitride compound layer on the surface layer side of said film.

The nitrogen to titanium (nitrogen/titanium) atomic ratio in the TiNₓ target used in the present invention is preferably not greater than 0.85, and more preferably not greater than 0.70. A target with a composition close to the stoichiometric composition with a nitrogen/titanium atomic ratio exceeding 0.85 is poor in sintering quality. This is because of generation of an increased number of macroparticles in the film formed by sputtering.

The heat treatment in the present invention may or may not be accompanied by a thermal nitriding reaction which supplies nitrogen to the TiNₓ film from a gaseous phase. However, the more the titanium content in the TiNₓ film exceeds that of the stoichiometric composition, the less becomes the thickness of the titanium nitride layer formed by transfer of nitrogen in the inside of the TiNₓ film, so that in case the nitrogen/titanium atomic ratio is less than 0.5, it is advisable to let a thermal nitriding reaction accompany the heat treatment for securing sufficient thickness of the titanium nitride layer.

The nitrogen to titanium atomic ratio in the target used is preferably 0.1 or above, and more preferably 0.2 or above.

The thickness ratio of the titanium nitride layer to the titanium silicide layer obtained from the TiNₓ film is preferably 0.7 or above.

According to the above-described method, there can be obtained a novel LSI having ohmic contact with a diffusion preventive film composed of a titanium nitride layer and a titanium silicide layer of which the combined thickness is as small as 150 nm (1,500Å) or less, with the titanium nitride layer to titanium silicide layer thickness ratio being not greater than 0.7.

In the present invention, the combined thickness of the titanium nitride layer and the titanium silicide layer is defined to be 150 nm (1,500 Å) or less for the reason that the thickness exceeding the specified value is unable to comply with the request for higher integration of LSI. Also, the titanium nitride layer to titanium silicide layer thickness ratio is defined to be 0.7 or above because a satisfactory diffusion preventive effect by the titanium nitride layer can be obtained by making said thickness ratio 0.7 or above.

The underlying technique of the present invention is sputtering of a TiNₓ target for obtaining a TiNₓ film for the siliciding treatment as described above.

By siliciding a TiNₓ film formed by sputtering of a TiNₓ film, it is possible to obtain a more uniform titanium silicide layer than when siliciding a TiNₓ film obtained by the conventional ion plating method in which pure titanium is vaporized and reacted with gaseous phase nitrogen. The reason for this is not known but may be related to the following facts.

In the present invention in which a TiNₓ target is sputtered, the sputtering particles are substantially those of the film composition, and there exist few factors that could cause segregation of the titanium atoms in the film forming process.

Also, in the present invention, the sputtering particles impinge against a silicon substrate to form a film and the film is cooled rapidly, so that it becomes amorphous or microcrystalline.

Therefore, in the TiNₓ film obtained in the present invention, the titanium atoms are evenly distributed in the plane, and also there exist a legion of crystal growth points at the interface with the silicon substrate, so that the titanium silicide layer formed in the ensuing heat treatment becomes uniform in thickness.

On the other hand, in the conventional ion plating method, because of use of pure titanium as target, it needs to react the pure titanium vapor with gaseous phase nitrogen, and in this case, unreacted titanium tends to remain in the film, causing segregation of titanium in the film, so that titanium silicide is produced with an insular formation.

As described above, the present invention features generation of titanium silicide from a TiNₓ film which has been subjected to sputtering from a target. In the siliciding reaction in the present invention, titanium of an amount in excess of the stoichiometric composition in the TiNₓ film participates in the reaction.

Therefore, in the present invention, it is not that the thicknesses of the titanium nitride and titanium silicide layers are decided only by the reaction rates of the nitriding reaction and the siliciding reaction as in the conventional method in which pure titanium is heat treated in a nitrogen atmosphere to form a titanium nitride layer and a titanium silicide layer. According to the present invention, since the amount of titanium that can take part in the siliciding reaction is limited, the thickness of the titanium silicide layer is restricted and thus formation of a titanium nitride layer with a minimum thickness is ensured.

The above-described method of the present invention can eliminate the disadvantage of the conventional method using a pure titanium film whereby the titanium silicide layer is formed more than necessary, and thus it is a very convenient method for forming ohmic contact.

### Example 1

Titanium nitride powder with a purity of 99.99% or above and an average crystal particle size of 40 µm, which had a stoichiometric composition with a nitrogen to titanium atomic ratio of 1, and pure titanium powder with a purity of 99.99% or above and an average particle size of 40µm were blended by a V blender in such a mixing ratio that the nitrogen to titanium atomic ratio would become 0.00-0.92. When the nitrogen to titanium atomic ratio is 0.00, it means that pure titanium powder alone was used as starting material.

The obtained mixed powder was packed in the 133 mmφ capsules for hot hydrostatic pressing, then subjected to hot hydrostatic pressing under the conditions of 1,250°C, 5 hours and 120 MPa and machined to a size of 75 mmφ x 6 mmt to obtain the TiNₓ targets.

The relation between the nitrogen to titanium atomic ratio (N/Ti) and relative density in the obtained targets is shown in Table 1.

By using the targets shown in Table 1, sputtering was carried out on a 152,4 mm (6-inch) diameter silicon wafer under the sputtering conditions shown in Table 2 to form a 100 nm (1,000 Å) TiNₓ film. No significant difference was admitted between the TiNₓ film composition and the target composition.

The number of the undesirable particles of 0.3 µm or greater produced on each of the obtained TiNₓ films was counted. The results are shown in Table 1.

**Table 1**

| No. | Target | | Number of particles produced (per 152,4 mm (6") wafer) | |
|---|---|---|---|---|
| | N/Ti atomic ratio | Relative density (%) | | |
| 1 | 0.00 | >99 | 14 | Comparative example |
| 2 | 0.11 | >99 | 15 | Example of this invention |
| 3 | 0.20 | >99 | 13 | Example of this invention |
| 4 | 0.40 | >99 | 16 | Example of this invention |
| 5 | 0.51 | >99 | 14 | Example of this invention |
| 6 | 0.70 | 99 | 21 | Example of this invention |
| 7 | 0.85 | 94 | 62 | Example of this invention |
| 8 | 0.92 | 87 | 103 | Example of this invention |

**Table 2**

| | Film forming conditions |
|---|---|
| Substrate temperature | 300°C |
| Base pressure | <3.0 x 10⁻⁴ Pa |
| Gas composition | 100% Ar |
| Working gas pressure | 0.6 Pa |

As seen from Table 1, the targets with a nitrogen to titanium atomic ratio exceeding 0.85 are low in sintering density and also produce a large number of particles.

Each of the silicon wafers having a TiNₓ film formed thereon was divided and subjected to either of the following two types of heat treatment:
(1) Heat treatment under a vacuum of 10⁻³ Pa at 700°C for one minute (hereinafter referred to as simple heat treatment).
(2) Heat treatment accompanied by a thermal nitriding reaction under normal pressure in an ammonia atmosphere at 735°C for one minute (hereinafter referred to as thermal nitriding treatment).

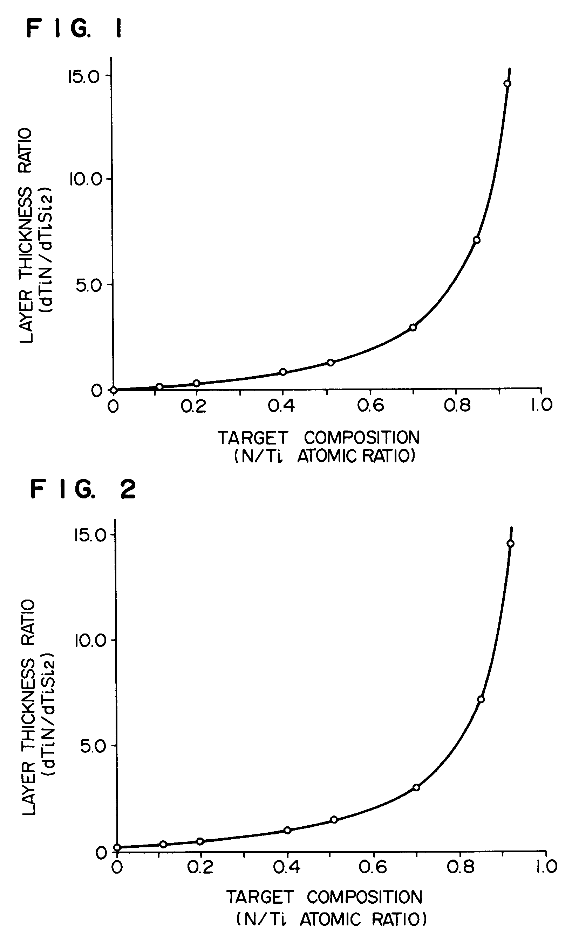

The relation between the thickness ratio of the titanium nitride layer to the titanium silicide layer obtained after the above heat treatments (this thickness ratio being indicated as dTiN/dTiSi₂) and the nitrogen to titanium atomic ratio (N/Ti atomic ratio) of the target used is shown in Fig. 1 in the case of simple heat treatment and in Fig. 2 in the case of thermal nitriding treatment.

The thickness of the titanium nitride layer and the titanium silicide layer was determined from ESCA analysis. The surfaces of all of the obtained samples assumed a gold color indicating titanium nitride of the stoichiometric amount.

It is seen from Fig. 1 that the titanium nitride layer to titanium silicide layer thickness ratio can be notably raised by increasing the nitrogen content in the target.

It is also noted that said thickness ratio elevates conspicuously when the nitrogen to titanium atomic ratio in the target is 0.2 or greater.

From Fig. 2, it is understood that in case of using a pure titanium target of the comparative example, even if the obtained pure titanium film is subjected to the thermal nitriding treatment, the titanium nitride layer to titanium silicide layer thickness ratio is as small as 0.11. In this case, the thickness of the titanium silicide layer is enlarged, making it unable to give a sufficient thickness to the diffusion preventive layer.

On the other hand, it is seen that in the case of the TiNₓ film obtained by sputtering with a titanium nitride target with a higher titanium content than the stoichiometric composition as in the present invention, it is possible to easily obtain a diffusion preventive layer structure with a high titanium nitride layer to titanium silicide layer thickness ratio by elevating the nitrogen to titanium atomic ratio.

Under the thermal nitriding treatment conditions in the instant example, although it was possible to increase the titanium nitride layer to titanium silicide layer thickness ratio as compared with the case of simple heat treatment, the rate of increase was small and no much difference was admitted in thickness ratio when the nitrogen to titanium atomic ratio in the target was 0.5 or above.

In order to evaluate uniformity of the titanium silicide layer formed, a section of each of the obtained diffusion preventive layer structures was observed with a scanning electron microscope at 30,000 magnification.

In case the TiNₓ target of the present invention was used, there was admitted no portion where the formed titanium silicide layer was insular, and it was confirmed that the titanium silicide layer was formed with a substantially uniform thickness.

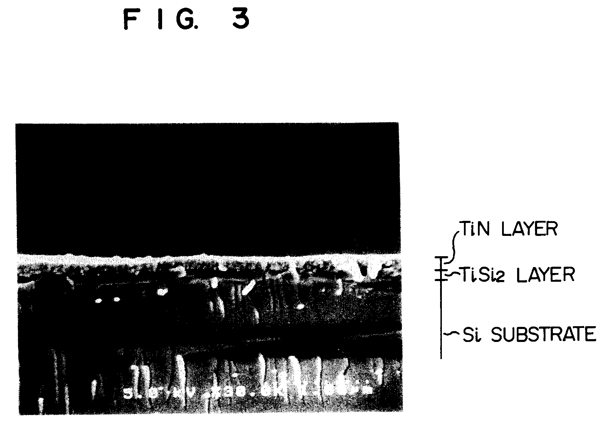

Fig. 3 is a photographic representation of a typical example of thin film having a titanium nitride layer and a titanium silicide layer obtained by carrying out the simple heat treatment using a target with a nitrogen to titanium atomic ratio of 0.40 according to the present invention.

As seen from Fig. 3, the titanium silicide layer obtained according to the present invention is substantially uniform in thickness, and its uniformity is of very high level that was quite unobtainable with the prior art.

According to the present invention, as described above, it is possible to form a titanium silicide layer with a small and uniform thickness by heat treating a TiNₓ film obtained by sputtering with a TiNₓ target with a greater titanium content than the stoichiometric composition, and this has made it possible to form a diffusion preventive layer made of titanium nitride with no risk of breaking the thin doped layer.

Thus, the present invention conforms to the recent trend toward higher integration of LSI by forming a doped layer with a smaller thickness, and therefore it can become a very useful means for production of LSI.

## Claims

1. An LSI ohmic contact forming method which comprises carrying out sputtering on a silicon substrate by using a target substantially composed of titanium and nitrogen and having a nitrogen to titanium atomic ratio of less than 1 to form on said silicon substrate a thin film of a titanium and nitrogen composition in which the nitrogen to titanium atomic ratio is less than 1, and then subjecting said thin film to a heat treatment to let said film react with silicon to form titanium silicide on the silicon side of said thin film.

2. An LSI ohmic contact forming method which comprises carrying out sputtering on a silicon substrate by using a target substantially composed of titanium and nitrogen and having a nitrogen to titanium atomic ratio of less than 1 to form on said silicon substrate a thin film of a titanium and nitrogen composition in which the nitrogen to titanium atomic ratio is less than 1, and then subjecting said thin film to a heat treatment to let said film react with silicon to form a titanium silicide layer on the silicon side of said thin film while forming a titanium nitride compound layer on the surface side of said film.

3. The method according to claim 1 or 2, wherein the nitrogen to titanium atomic ratio in the target is 0.10 to 0.85.

4. The method according to claim 1 or 2, wherein the nitrogen to titanium atomic ratio in the target is 0.20 to 0.70.

5. The method according to Claim 1 or 2, wherein the heat treatment is not accompanied by the thermal nitriding reaction from the surface of said film.

6. The method according to Claim 1 or 2, wherein the heat treatment is accompanied by the thermal nitriding reaction from the surface of said film.

7. An LSI having for its ohmic contact a diffusion preventive layer structure in which the combined thickness of the titanium nitride layer and the titanium silicide layer is 1,500 Å or less, and the titanium nitride layer to titanium silicide layer thickness ratio is 0.7 or above.
